# EUROPÄISCHE PATENTSCHRIFT

(11) **EP 2 832 197 B1**
(45) Veröffentlichungstag und Bekanntmachung des Hinweises auf die Patenterteilung: **21.03.2018**
(21) Anmeldenummer: 13712225.5
(22) Anmeldetag: 22.03.2013
(51) Int. Cl.: H05K 7/14, H01R 9/26, H05K 5/02, H05K 1/02, H01R 13/53

(54) **VERSCHIEBBARE ISOLATIONSBARRIERE**
DISPLACEABLE INSULATION BARRIER
BARRIÈRE D'ISOLATION DÉPLAÇABLE

(30) Priorität: 26.03.2012 DE 102012102567
(43) Veröffentlichungstag der Anmeldung: 04.02.2015
(73) Patentinhaber: Phoenix Contact GmbH & Co. KG, 32825 Blomberg (DE)
(72) Erfinder: BEST, Frank, 31675 Bückeburg (DE); SEELIG, Marco, 33818 Leopoldshöhe (DE)
(74) Vertreter: Michalski Hüttermann & Partner Patentanwälte mbB
(86) Internationale Anmeldenummer: PCT/EP2013/056136
(87) Internationale Veröffentlichungsnummer: WO 2013/144032

(56) Entgegenhaltungen:
- DE-A1- 19 757 938
- DE-A1-102006 052 211
- DE-A1-102009 005 546
- DE-U1-202005 017 012

## Beschreibung

Die Erfindung betrifft eine Anordnung zur Erhöhung der Isolationskoordination zwischen wenigstens zwei elektrischen Potentialen auf einer Leiterplatte. Ferner betrifft die Erfindung ein Einbaugehäuse zur Montage an einer Tragschiene, mit einer innerhalb des Gehäuses angeordneten Anordnung. Schließlich betrifft die Erfindung ein Verfahren zum Erhöhen der Isolationskoordination zwischen wenigstens zwei elektrischen Potentialen auf einer Leiterplatte.

Aus dem Stand der Technik ist bekannt, Leiterplatten mit elektrischen Bauelementen zu versehen, wie beispielsweise einer Grundleiste, welche einerseits über einen Lötanschluss mit einer Leiterbahn der Leiterplatte elektrisch verbunden ist und andererseits eine elektrische Kontaktierung mit einem zu der Grundleiste korrespondierenden Steckverbinder ermöglicht. Eine derartige Leiterplatte ist dann in ein Einbaugehäuse einführbar, das an einer Tragschiene eines Schaltschranks befestigbar ist.

DE 10 2009 005546 A1 beschreibt ein Steckverbinderteil, umfassend ein isolierendes Teil, insbesondere Kunststoffteil, an dem eine Ausnehmung, insbesondere zweite Ausnehmung, ausgeformt ist, wobei in dem isolierenden Teil Anschlussstifte aufgenommen sind.

DE 10 2006 052 211 A1 beschreibt Elektrisches Anschlusselement zum Anschluss eines Leiters an eine Leiterplatte, umfassend ein Gehäuse, mindestens einen Klemmanschluss für den Leiter sowie mindestens zwei Anschlusspins zur vorzugsweise lötbaren Verbindung mit der Leiterplatte.

DE 20 2005 017 012 U1 beschreibt eine elektrische Anschlusseinrichtung für eine Leiterplatte.

Sofern nun die Potentiale auf der Leiterplatte ein vergleichbares Niveau aufweisen, ist eine sogenannte Basisisolierung, auch Funktionsisolierung genannt, ausreichend, um eine entsprechend hohe Isolation zwischen beispielsweise den Lötanschlüssen zweier unterschiedlicher Grundleisten zu gewährleisten. In diesem Zusammenhang spricht man auch von der Isolationskoordination, also der gegenseitigen Abstimmung der elektrischen Isolierungen der elektrischen Potentiale der Leiterplatte sowie dem Stehvermögen vorgenannter Isolierungen andererseits. Gerade für den Hochspannungsbereich schreiben verschiedene Normen, wie die DIN EN 60664, die benötigte Ausgestaltung der Isolation, also beispielsweise der Luft- und/oder Kriechstrecken, vor.

Sofern nun unterschiedliche Potentiale auf der Leiterplatte geführt werden, so also eine "hohe Spannung" von beispielsweise 630 V als auch eine "tiefe Spannung", eine sogenannte Schutzkleinspannung, von beispielsweise 120 V, ist die Isolierung als sogenannte doppelte Isolierung auszugestalten, was bedeutet, dass die Luft- und/oder Kriechstrecken entsprechend größer als bei einer Basisisolierung auszugestalten sind. Konkret bedeutet dies, dass zwischen Grundleisten, die unterschiedlich hohe Potentiale führen, größere Abstände vonnöten sind, was wiederum in einem größeren Flächenbedarf und einer geringeren Packungsdichte der elektrischen Bauelemente resultiert.

Der Erfindung liegt daher die Aufgabe zugrunde, eine Möglichkeit anzugeben, wie auch Potentiale unterschiedlichen Niveaus auf einer Leiterplatte geführt werden können, wobei trotzdem eine hohe Packungsdichte der elektrischen Bauelemente erzielt werden kann.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Demnach liegt eine Lösung der Aufgabe in einer Anordnung zur Erhöhung der Isolationskoordination zwischen wenigstens zwei elektrischen Potentialen auf einer Leiterplatte, mit der Leiterplatte und einer Isolationsbarriere, wobei die Leiterplatte zwischen den elektrischen Potentialen eine Öffnung aufweist und die Isolationsbarriere verschiebbar durch die Öffnung hindurch derart an der Leiterplatte angeordnet und ausgestaltet ist, dass durch Verschieben der Isolationsbarriere relativ zu der Leiterplatte die Isolationsstrecke zwischen den beiden elektrischen Potentialen vergrößerbar ist.

Es ist also ein wesentlicher Punkt der Erfindung, dass zwischen den wenigstens zwei elektrischen Potentialen, also beispielsweise zwischen einem Potential mit "hoher Spannung" sowie einem Potential mit "tiefer Spannung", eine verschiebbare Isolationsbarriere vorgesehen ist, die durch die Öffnung der Leiterplatte hindurch "zwischen" die Potentiale einschiebbar ist, so dass dadurch die Luft- und/oder Kriechstrecken zwischen den Potentialen vergrößert werden. Mit anderen Worten bedeutet dies, dass durch die verschiebbare Isolationsbarriere die Isolationskoordination zwischen den elektrischen Potentialen erhöhbar ist. Denn dadurch, dass in verschobenem Zustand die Isolationsbarriere "zwischen" den elektrischen Potentialen angeordnet ist, ist die Isolationsstrecke zwischen den elektrischen Potentialen entsprechend vergrößert. Dabei ist die Vergrößerung der Isolationsstrecke einerseits abhängig von der "Breite" der Isolationsbarriere sowie andererseits davon, "wie weit" die Isolationsbarriere durch die Öffnung der Leiterplatte hindurchgeschoben ist bzw. über die Oberfläche der Leiterplatte hinausragt.

Die Anordnung ermöglicht somit, dass auch bei der Beaufschlagung der Leiterplatte mit unterschiedlich hohen Potentialen, so beispielsweise 630 V gegenüber 50 V Wechselspannung oder 120 V Gleichspannung, eine ausreichende Isolation zwischen den unterschiedlichen Potentialen gewährleistet wird, so dass eine hohe Packungsdichte auf der Leiterplatte erreicht werden kann.

Die Erfindung ermöglicht zudem, dass die verschiebbare Isolationsbarriere auch nachträglich vorsehbar ist, indem zwischen den elektrischen Potentialen eine Öffnung oder ein Ausbruch in die Leiterplatte eingebracht wird, in die dann die Isolationsbarriere, welche vorzugsweise aus einem Kunststoff ausgestaltet ist, eingeführt wird, um die Isolationsstrecken zwischen den elektrischen Potentialen umzuleiten, also zu vergrößern.

Ein weiterer Vorteil der Erfindung ist, dass keine aufwändige zusätzliche Isolation geschaffen werden muss, wenn eine Leiterplatte, welche bislang mit Potentialen vergleichbaren Niveaus beaufschlagt worden ist und dementsprechend hinsichtlich der Luft- und Kriechstrecken dimensioniert worden ist, nunmehr in einem geänderten Anwendungsfall mit Potentialen unterschiedlicher Höhe beaufschlagt wird, was im Stand der Technik prinzipiell immer einen Austausch der Leiterplatte erforderlich gemacht hat. Für einen derartigen geänderten Anwendungsfall kann dann eine Öffnung in die Leiterplatte eingebracht werden und eine zwischen die Potentiale einschiebbare Isolationsbarriere zum Vergrößern der Luft- und/oder Kriechstrecken vorgesehen werden.

Sofern im Rahmen der Erfindung von elektrischen Potentialen gesprochen wird, so werden dabei insbesondere Spannungen verstanden, die auf der Leiterplatte vorzugsweise zwischen Leiterbahnen, Lötanschlüssen aktiver und/oder passiver Bauteile und/oder Masse bzw. Erde zu bestimmen sind. Mit Isolationsbarriere ist prinzipiell jedes Bauteil gemeint, das in eine Öffnung der Leiterplatte derart einschiebbar ist, dass im eingeschobenen Zustand die Isolationsbarriere zwischen den elektrischen Potentialen eine Verlängerung der Isolationsstrecke, vorzugsweise der Luft- und/oder Kriechstrecken, bewirkt. Die Isolationsbarriere kann beispielsweise die Form eines länglichen Blechs oder aber ein Profil, so ein U-Profil, aufweisen.

Sofern im Rahmen der Erfindung davon die Rede ist, dass durch Verschieben der Isolationsbarriere relativ zur Leiterplatte die Isolationsstrecke zwischen den beiden elektrischen Potentialen vergrößerbar ist, bedeutet dies insbesondere, dass die Isolationsstrecke zwischen den wenigstens zwei elektrischen Potentialen kleiner ist, wenn die Isolationsbarriere nicht an der Leiterplatte angeordnet ist und insbesondere nicht durch die Öffnung hindurch geschoben ist, als wenn die Isolationsbarriere durch die Öffnung der Leiterplatte hindurch geschoben ist. Wenn also vom verschobenen Zustand der Isolationsbarriere durch die Öffnung hindurch die Rede ist, so meint dies insbesondere den Zustand, wenn die Isolationsbarriere in die Öffnung eingeführt ist, sich aufgrund ihrer Erstreckung gleichzeitig aus der Öffnung heraus weg von der Oberfläche der Leiterplatte erstreckt und dabei derart zwischen den elektrischen Potentialen angeordnet ist, dass dadurch die Luft- und/oder Kriechstrecken zwischen den elektrischen Potentialen vergrößert sind.

Nach der Erfindung ist ferner vorgesehen, dass die Anordnung wenigstens zwei elektrische Bauelemente aufweist, wobei die elektrischen Bauelemente durch Anschlüsse, vorzugsweise Lötanschlüsse, mit der Leiterplatte elektrisch verbunden sind, die Isolationsbarriere an einem der elektrischen Bauelemente derart verschiebbar angeordnet ist, dass im verschobenen Zustand der Isolationsbarrieren durch die Öffnung hindurch die Isolationsstrecke zwischen wenigstens einem Anschluss wenigstens eines Bauelements und wenigstens einem Anschluss wenigstens eines anderen Bauelements vergrößert ist. Die Bauelemente können dazu als beliebige aus dem Stand der Technik bekannte elektrische Bauelemente ausgestaltet sein, so beispielsweise als Grundleisten zum Anschließen von entsprechenden zu den Grundleisten korrespondierenden Steckverbindern.

Nach einer weiteren Ausführungsform der Erfindung ist bevorzugt, dass die Isolationsbarriere derart angeordnet und ausgestaltet ist, dass im verschobenen Zustand der Isolationsbarriere die Isolationsbarriere zwischen allen Anschlüssen wenigstens eines Bauelements und allen Anschlüssen wenigstens eines anderen Bauelements vergrößert ist. Bei den Anschlüssen handelt es sich vorzugsweise um Lötanschlüsse. Das bedeutet also, dass durch das Einschieben einer einzigen Isolationsbarriere in die Öffnung die Luft- und/oder Kriechstrecken zwischen allen Lötanschlüssen eines ersten Bauelements und allen Lötanschlüssen wenigstens eines zweiten Bauelements vergrößert ist, so dass, wenn die Bauelemente mit unterschiedlich hohen Potentialen beaufschlagt sind, eine bislang notwendige doppelte Isolierung bereits durch Vorsehen der einschiebbaren Isolationsbarriere gegeben ist.

Grundsätzlich kann die Isolationsbarriere beliebig ausgestaltet sein, wobei nach einer besonders bevorzugten Ausführungsform der Erfindung jedoch vorgesehen ist, dass die Isolationsbarriere als Schieberelement und vorzugsweise aus einem Kunststoff ausgestaltet ist. Weiterhin ist bevorzugt, dass das Bauelement und/oder die Isolationsbarriere derart ausgestaltet sind, dass die Isolationsbarriere lösbar an dem Bauelement befestigbar bzw. befestigt ist. Somit kann die Isolationsbarriere auch nachträglich an dem Bauelement befestigt werden oder aber erst nach dem Verlöten des Bauelements mit der Leiterplatte an dem Bauelement befestigt werden, so dass die Montage des Bauelements vereinfacht ist. Ebenfalls können bereits an einer Leiterplatte installierte Bauelemente nachträglich mit der Isolationsbarriere ausgestaltet werden, welche als Schieberelement besonders einfach bedienbar ist. Auch können mehrere Isolationsbarrieren an der Anordnung vorgesehen sein.

In diesem Zusammenhang ist weiterhin bevorzugt, dass das Schieberelement und das elektrische Bauelement, an dem das Schieberelement angeordnet ist, über eine Schwalbenschwanzführung zusammenwirken. Dadurch wird eine besonders sichere und verlässliche Führung gewährleistet, wobei grundsätzlich auch jede andere Art der Führung bzw. Verschiebbarkeit der Isolationsbarriere gegenüber der Leiterplatte bzw. dem Bauelement möglich ist.

Bei einer anderen Ausführungsform der Erfindung ist bevorzugt vorgesehen, dass die Isolationsbarriere senkrecht zur Erstreckung der Leiterplatte verschiebbar angeordnet ist. Alternativ kann die Verschiebung auch in einem Winkel von beispielsweise 60° oder 80° zur Oberfläche der Leiterplatte möglich sein.

Nach einer weiteren besonders bevorzugten Ausführungsform der Erfindung ist vorgesehen, dass die Isolationsbarriere in ihrem nicht durch die Öffnung hindurch verschobenen Zustand und/oder in ihrem durch die Öffnung hindurch verschobenen Zustand relativ zur Leiterplatte fixierbar ist. Dazu kann die Isolationsbarriere und/oder das Bauelement eine Rastung oder vergleichbares aufweisen, so dass die Isolationsbarriere wenigstens in ihrem verschobenen und nicht verschobenen Zustand an dem Bauelement verrastbar ist. Im nicht verschobenen Zustand wird eine einfache Konfektionierung des Bauteils an der Leiterplatte ermöglicht, da nicht erst die Isolationsbarriere durch die Öffnung hindurch geführt werden muss, um das Bauelement an der Leiterplatte, beispielsweise durch Löten, zu fixieren. Die Verrastung der durch die Öffnung hindurch verschobenen Isolationsbarriere bewirkt, dass bei Erschütterungen o.ä. der Leiterplatte bzw. der Isolationsbarriere diese in ihrer verschobenen Position verbleibt und damit in zuverlässiger Weise eine gegenüber dem nicht verschobenen Zustand verbesserte Isolation ermöglicht.

Die Aufgabe der Erfindung ist weiterhin gelöst durch ein Einbaugehäuse zur Montage einer Tragschiene, mit einer innerhalb des Gehäuses angeordneten mit einer wie vorab beschriebenen Anordnung. Da derartige Einbaugehäuse nicht selten nur einen äußerst begrenzten Platz bieten, ermöglicht die Erfindung eine hohe Packungsdichte auch wenn Potentiale unterschiedlichstem Niveau auf der Leiterplatte geführt werden. Dabei ist die verschiebbare Isolationsbarriere vorzugsweise zwischen Gehäusewänden des Einbaugehäuses lagefixiert gehalten.

Weitere Ausgestaltungen und Vorteile des Einbaugehäuses ergeben sich für den Fachmann in naheliegender Weise aus den obigen Ausführungen zur Anordnung.

Die Aufgabe der Erfindung ist weiterhin gelöst durch ein Verfahren zum Erhöhen der Isolationskoordination zwischen wenigstens zwei elektrischen Potentialen auf einer Leiterplatte, mit der Leiterplatte und einer Isolationsbarriere, wobei die Leiterplatte zwischen den elektrischen Potentialen eine Öffnung aufweist und das Verfahren den Schritt aufweist: Verschieben der Isolationsbarriere von einer ersten Position, in der die Isolationsbarriere nicht durch die Öffnung hindurch verschoben ist, in eine zweite Position, in der die Isolationsbarriere durch die Öffnung hindurch verschoben ist.

Somit ist also ein wesentlicher Punkt des Verfahrens, dass durch Verschieben der Isolationsbarriere von der ersten Position in die zweite Position die Isolationskoordination zwischen den wenigstens zwei elektrischen Potentialen erhöhbar ist, nämlich dadurch, dass in der zweiten Position die Luft- und/oder Kriechstrecken zwischen den durch die Isolationsbarriere "getrennten" elektrischen Potentialen vergrößert ist.

Weitere Ausgestaltungen und Vorteile des Verfahrens ergeben sich für den Fachmann in Analogie zu der oben beschriebenen Anordnung.

Nachfolgend wird die Erfindung unter Bezugnahme auf die anliegende Zeichnung anhand einer bevorzugten Ausführungsform näher erläutert.

Es zeigen
- Fig. 1: ein Einbaugehäuse zur Montage an einer Tragschiene gemäß einer bevorzugten Ausführungsform der Erfindung,
- Fig. 2: eine Anordnung mit einer Leiterplatte, einer Isolationsbarriere und einem elektrischen Bauelement gemäß dem bevorzugten Ausführungsbeispiel der Erfindung,
- Fig. 3: einen rückseitigen Ausschnitt der Fig. 2, und
- Fig. 4: ein elektrisches Bauelement mit der Isolationsbarriere gemäß der bevorzugten Ausführungsform der Erfindung.

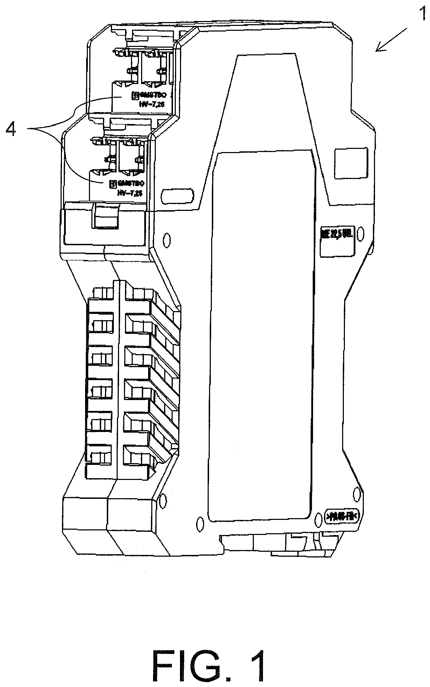

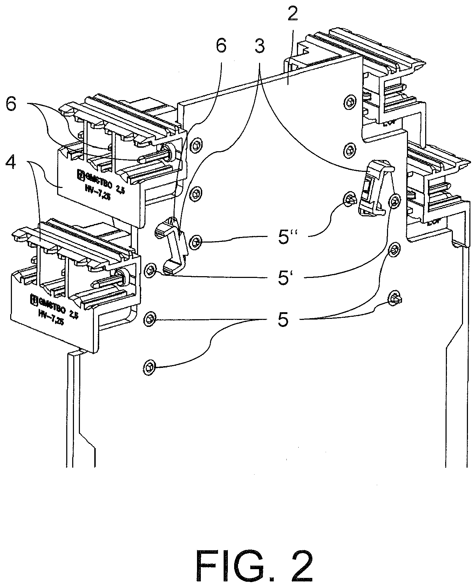

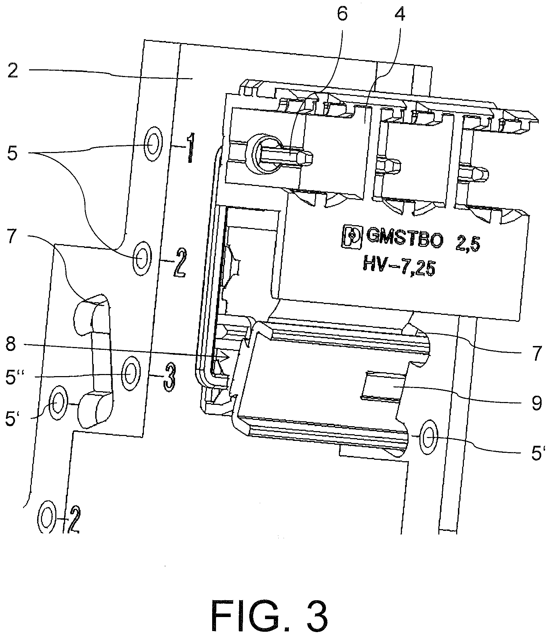

Die Fig. 1 zeigt ein Einbaugehäuse 1 zur Montage an einer Tragschiene, nicht gezeigt, mit einer innerhalb des Gehäuses 1 angeordneten Leiterplatte 2 sowie einer Isolationsbarriere 3, jeweils gezeigt in Fig. 2 und Fig. 3, sowie elektrischen Bauelementen 4, welche ebenfalls in Fig. 2 bis 4 gezeigt sind.

Die elektrischen Bauelemente 4 sind vorliegend als Grundleisten ausgestaltet, in welche zu den Grundleisten 4 korrespondierende Steckverbinder, nicht gezeigt, einsteckbar sind. Über Lötanschlüsse 5 sind die elektrischen Kontakte 6 der Bauelemente 4 mit Leiterbahnen, nicht gezeigt, der Leiterplatte 2 verbunden.

Um nun die Isolationsstrecke zwischen zwei elektrischen Potentialen der Leiterplatte 2 zu erhöhen, so konkret zwischen den mit Strichen gekennzeichneten Lötanschlüssen 5' und 5", weist die Leiterplatte 2 eine Öffnung 7 auf, in die die Isolationsbarriere 3, wie in Fig. 2 und Fig. 3 gezeigt, eingeführt ist und somit die Luft- und/oder Kriechstrecke zwischen wenigstens den beiden Lötanschlusspunkten 5', 5" vergrößert.

Denn durch derartiges Vorsehen der Isolationsbarriere 3, also wenn die Isolationsbarriere 3 wie in Fig. 2 gezeigt zwischen den Lötanschlüssen 5', 5" angeordnet ist, sind die Isolationsstrecken wenigstens zwischen diesen beiden Lötanschlüssen 5', 5" verlängert.

Das bedeutet, dass bei gleichbleibend hoher Packungsdichte unterschiedliche Potentiale auf der Leiterplatte 2 führbar sind, nämlich vorliegend einmal eine Schutzkleinspannung von 50 V Wechselspannung oder 120 V Gleichspannung an dem Lötanschluss 5' sowie eine Spannung bis 630 V an dem zweiten Lötanschluss 5", ohne dass, wie bei aus dem Stand der Technik bekannten Anordnungen, die Isolation aufwendig erhöht werden muss.

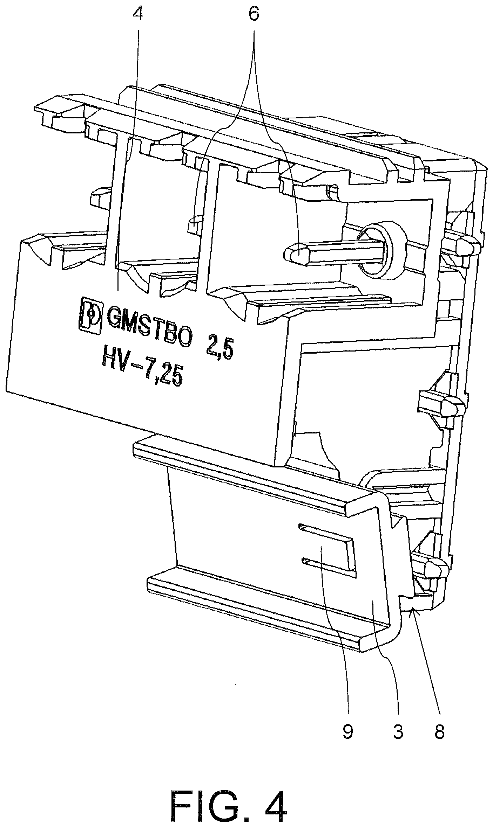

Die Isolationsbarriere 3, welche vorliegend aus einem Kunststoff ausgestaltet ist, ist, wie in Fig. 3 und Fig. 4 im Detail ersichtlich, an dem elektrischen Bauelement 4 verschiebbar geführt, nämlich über eine Schwalbenschwanzführung 8. Derart ausgestaltet ist die Isolationsbarriere 3 als Schieberelement senkrecht zur Erstreckung der Leiterplatte 2 relativ zur Leiterplatte 2 durch die Öffnung 7 hindurch verschiebbar, und zwar von einer ersten Position, in der die Isolationsbarriere 3 nicht durch die Öffnung 7 hindurch verschoben ist, in eine zweite Position, wie in Fig. 2 gezeigt, in der die Isolationsbarriere 3 durch die Öffnung 7 hindurch verschoben ist.

Ferner weist die Isolationsbarriere 3 bzw. das elektrische Bauelement 4 eine Verrastung 9 zur Fixierung der Isolationsbarriere 3 in der ersten Position sowie in der zweiten Position auf.

Zur Montage der Isolationsbarriere gibt es grundsätzlich mehrere Möglichkeiten. Zum einen kann die Isolationsbarriere 3, welche vorliegend ein U-artiges Profil aufweist, nachträglich an einem bereits an der Leiterplatte 2 vorgesehenen Bauteil 4 befestigt werden und in eine entweder bereits an der Leiterplatte 2 vorgesehene oder nachträglich gefräste Öffnung 7 eingeführt werden.

Alternativ kann eine bereits an einem Bauelement 4 vorgesehene Isolationsbarriere 3 zunächst durch Aufbringen des Bauelements 4 an der Leiterplatte 2 mittels Verlöten der Lötanschlüsse 5 fixiert werden und dann in einem zweiten Schritt durch die Öffnung 7 hindurch geschoben werden, um, wie in Fig. 2 gezeigt, die Isolationsstrecken wenigstens zwischen den beiden Lötanschlusspunkten 5', 5" zu verlängern.

**Bezugszeichenliste**

| | |
|---|---|
| Gehäuse | 1 |
| Leiterplatte | 2 |
| Isolationsbarriere | 3 |
| Bauelement | 4 |
| Lötanschluss | 5, 5', 5" |
| Elektrischer Kontakt | 6 |
| Öffnung | 7 |
| Schwalbenschanzführung | 8 |
| Verrastung | 9 |

## Patentansprüche

1. Anordnung zur Erhöhung der Isolationskoordination zwischen wenigstens zwei elektrischen Potentialen auf einer Leiterplatte (2), mit der Leiterplatte (2), einer Isolationsbarriere (3) und wenigstens zwei elektrischen Bauelementen (4), wobei
die Leiterplatte (2) zwischen den elektrischen Potentialen eine Öffnung (7) aufweist,
die Isolationsbarriere (3) verschiebbar durch die Öffnung (7) hindurch derart an der Leiterplatte (2) angeordnet und ausgestaltet ist, dass durch Verschieben der Isolationsbarriere (3) relativ zu der Leiterplatte (2) die Isolationsstrecke zwischen den beiden elektrischen Potentialen vergrößerbar ist,
die elektrischen Bauelemente (4) durch Anschlüsse (5) mit der Leiterplatte (2) elektrisch verbunden sind,
**dadurch gekennzeichnet, dass** die Isolationsbarriere (3) an einem der elektrischen Bauelemente (4) derart verschiebbar angeordnet ist, dass im verschobenen Zustand der Isolationsbarriere (3) durch die Öffnung (7) hindurch die Isolationsstrecke zwischen wenigstens einem Anschluss (5') wenigstens eines Bauelements (4) und wenigstens einem Anschluss (5") wenigstens eines anderen Bauelements (4) vergrößert ist.

2. Anordnung nach dem vorhergehenden Anspruch, wobei die Isolationsbarriere (3) derart angeordnet und ausgestaltet ist, dass im verschobenen Zustand der Isolationsbarriere (3) die Isolationsstrecke zwischen allen Anschlüssen (5, 5') wenigstens eines Bauelements (4) und allen Anschlüssen (5, 5") wenigstens eines anderen Bauelements (4) vergrößert ist.

3. Anordnung nach einem der vorhergehenden Ansprüche, wobei die Isolationsbarriere (3) als Schieberelement und/oder aus einem Kunststoff ausgestaltet ist.

4. Anordnung nach einem der drei vorhergehenden Ansprüche, wobei das Bauelement (4) und/oder die Isolationsbarriere (3) derart ausgestaltet sind, dass die Isolationsbarriere (3) lösbar an dem Bauelement (4) befestigbar ist.

5. Anordnung nach einem der vier vorhergehenden Ansprüche, wobei die Isolationsbarriere (3) als Schieberelement ausgestaltet ist und das Schieberelement und das elektrische Bauelement (4), an dem das Schieberelement angeordnet ist, über eine Schwalbenschwanzführung (8) zusammenwirken.

6. Anordnung nach einem der vorhergehenden Ansprüche, wobei die Isolationsbarriere (3) senkrecht zur Erstreckung der Leiterplatte (2) verschiebbar ist.

7. Anordnung nach einem der vorhergehenden Ansprüche, wobei die Isolationsbarriere (3) in ihrem nicht durch die Öffnung (7) hindurch verschobenen Zustand und/oder in ihrem durch die Öffnung (7) hindurch verschobenen Zustand relativ zur Leiterplatte (2) fixierbar ist.

8. Einbaugehäuse (1) zur Montage an einer Tragschiene, mit einer innerhalb des Gehäuses (1) angeordneten Anordnung nach einem der vorhergehenden Ansprüche.

9. Einbaugehäuse (1) nach Anspruch 8, wobei die verschiebbare Isolationsbarriere (3) durch Gehäusewände des Gehäuses (1) lagefixiert gehalten ist.

10. Verfahren zum Erhöhen der Isolationskoordination zwischen wenigstens zwei elektrischen Potentialen auf einer Leiterplatte (2), wobei
die Leiterplatte (2) zwischen den elektrischen Potentialen eine Öffnung (7) aufweist,
eine Isolationsbarriere (3) verschiebbar durch die Öffnung (7) an der Leiterplatte (2) angeordnet ist,
wenigstens zwei elektrische Bauelemente (4) durch Anschlüsse (5) mit der Leiterplatte (2) elektrisch verbunden sind, und
folgender Schritt durchgeführt wird:
Verschieben der Isolationsbarriere (3) von einer ersten Position, in der die Isolationsbarriere (3) nicht durch die Öffnung (7) hindurch verschoben ist, in eine zweite Position, in der die Isolationsbarriere (3) durch die Öffnung (7) hindurch verschoben ist,
**dadurch gekennzeichnet, dass**
die Isolationsbarriere (3) an einem der elektrischen Bauelemente (4) derart verschiebbar angeordnet ist, dass im verschobenen Zustand der Isolationsbarriere (3) durch die Öffnung (7) hindurch die Isolationsstrecke zwischen wenigstens einem Anschluss (5') wenigstens eines Bauelements (4) und wenigstens einem Anschluss (5") wenigstens eines anderen Bauelements (4) vergrößert ist.

## Claims

1. An arrangement for increasing the insulation coordination between at least two electric potentials on a printed circuit board (2), said arrangement comprising the printed circuit board (2), an insulation barrier (3) and at least two electrical components (4), wherein
the printed circuit board (2) has an opening (7) between the electric potentials, and
the insulation barrier (3) is disposed on the printed circuit board (2) so as to be displaceble through the opening (7) and is designed such that the isolating distance between the two electric potentials can be enlarged by displacing the insulation barrier (3) relative to the printed circuit board (2),
the electrical components (4) are electrically connected to the printed circuit board (2) by terminals (5),
**characterized in that**
the insulation barrier (3) is displaceably disposed on one of the electrical components (4) such that, in the state in which the insulation barrier (3) has been slid through the opening (7), the isolating distance between at least one terminal (5') of at least one component (4) and at least one terminal (5") of at least one other component (4) is enlarged.

2. The arrangement according to the preceding claim, wherein the insulation barrier (3) is disposed and designed such that, in the displaced state of the insulation barrier (3), the isolating distance is enlarged between all terminals (5, 5') of at least one component (4) and all terminals (5, 5") of at least one other component (4) .

3. The arrangement according to any one of the preceding claims, wherein the insulation barrier (3) is designed as a slide element and/or made of a plastic.

4. The arrangement according to any one of the preceding claims, wherein the component (4) and/or the insulation barrier (3) are designed such that the insulation barrier (3) can be detachably secured on the component (4).

5. The arrangement according to any one of the four preceding claims, wherein insulation barrier (3) is designed as a slide element and the slide element and the electrical component (4), on which the slide element is disposed, interact via a dovetail guide (8).

6. The arrangement according to any one of the preceding claims, wherein the insulation barrier (3) is displaceable perpendicularly to the extension of the printed circuit board (2).

7. The arrangement according to any one of the preceding claims, wherein the insulation barrier (3) can be fixed in the state thereof in which said insulation barrier has not been slid through the opening (7) and/or can be fixed in the state thereof relative to the printed circuit board (2), in which said insulation barrier has been slid through the opening (7).

8. A built-in housing (1) for installation on a supporting rail, comprising an arrangement according to any one of the preceding claims, which is disposed within the housing (1).

9. The built-in housing (1) according to claim 8, wherein the displaceable insulation barrier (3) is held, fixed in position, between housing walls of the housing (1).

10. A method for increasing the insulation coordination between at least two electric potentials on a printed circuit board (2),
the printed circuit board (2) has an opening (7) between the electric potentials,
an insulation barrier (3) is arranged displaceable through the opening (7) at the printed circuit board (2),
at least two electrical components (4) are electrically connected to the printed circuit board (2) by terminals (5), and the step of:
displacing the insulation barrier (3) from a first position, in which the insulation barrier (3) has not been slid through the opening (7), into a second position, in which the insulation barrier has been slid through the opening (7),
**characterized in that**
the insulation barrier (3) is displaceably disposed on one of the electrical components (4) such that, in the state in which the insulation barrier (3) has been slid through the opening (7), the isolating distance between at least one terminal (5') of at least one component (4) and at least one terminal (5") of at least one other component (4) is enlarged.

## Revendications

1. Ensemble destiné à l'augmentation de la coordination d'isolation entre au moins deux potentiels électriques sur une carte de circuit imprimé (2), avec une carte de circuit imprimé (2), une barrière d'isolation (3) et au moins deux composants (4) électriques, où
la carte de circuit imprimé (2) présente une ouverture (7) entre les deux potentiels électriques,
la barrière d'isolation (3) est disposée de telle manière sur la carte de circuit imprimé (2), pouvant se déplacer en traversant l'ouverture (7) et est conçue de sorte que, par le déplacement de la barrière d'isolation (3) par rapport à la carte de circuit imprimé (2), la distance d'isolation entre les deux potentiels électriques peut être augmentée,
les composants (4) électriques sont reliés électriquement par des contacts (5) avec la carte de circuit imprimé (2),
**caractérisé en ce que**
la barrière d'isolation (3) est disposée en pouvant se déplacer sur l'un des composants (4) électriques de telle manière, qu'à l'état déplacé de la barrière d'isolation (3) à travers l'ouverture (7), la distance d'isolation est augmentée entre au moins un contact (5') d'au moins un composant (4) et au moins un contact (5") d'au moins un autre composant (4).

2. Ensemble selon la revendication précédente, dans lequel la barrière d'isolation (3) est disposée et conçue de telle manière, qu'à l'état déplacé de la barrière d'isolation (3), la distance d'isolation entre tous les contacts (5, 5') d'au moins un composant (4) et de tous les contacts (5, 5") d'au moins un autre composant (4) est augmentée.

3. Ensemble selon l'une des revendications précédentes, dans lequel la barrière d'isolation (3) est conçue sous la forme d'un élément coulissant et/ou à base d'une matière synthétique.

4. Ensemble selon l'une des trois revendications précédentes, dans lequel le composant (4) et/ou la barrière d'isolation (3) sont conçus de telle manière que la barrière d'isolation (3) peut être fixée sur le composant (4) de manière amovible.

5. Ensemble selon l'une des quatre revendications précédentes, dans lequel la barrière d'isolation (3) est conçue sous la forme d'un élément coulissant, et l'élément coulissant et le composant (4) électrique sur lequel est disposé l'élément coulissant agissent conjointement par le biais d'un assemblage en queue d'aronde (8).

6. Ensemble selon l'une des revendications précédentes, dans lequel la barrière d'isolation (3) peut être déplacée perpendiculairement par rapport à l'extension de la carte de circuit imprimé (2).

7. Ensemble selon l'une des revendications précédentes, dans lequel la barrière d'isolation (3) peut être fixée dans sa position non déplacée à travers l'ouverture (7), et/ou dans sa position déplacée à travers l'ouverture (7), par rapport à la carte de circuit imprimé (2).

8. Boîtier (1) encastrable destiné au montage sur un rail de support, avec un ensemble selon l'une des revendications précédentes disposé à l'intérieur du boîtier (1).

9. Boîtier (1) encastrable selon la revendication 8, dans lequel la barrière d'isolation (3) pouvant se déplacer à travers les parois de boîtier du boîtier (1) est maintenue fixe à une position.

10. Procédé destiné à l'augmentation de la coordination d'isolation entre au moins deux potentiels électriques sur une carte de circuit imprimé (2), dans lequel
la carte de circuit imprimé (2) présente une ouverture (7) entre les potentiels électriques,
la barrière d'isolation (3) est disposée sur la carte de circuit imprimé (2) en pouvant se déplacer à travers l'ouverture (7),
au moins deux composants (4) électriques sont reliés électriquement par des contacts (5) avec la carte de circuit imprimé (2), et
l'étape suivante est exécutée :
le déplacement de la barrière d'isolation (3) à partir d'une première position, dans laquelle la barrière d'isolation (3) n'est pas déplacée à travers l'ouverture (7), vers une deuxième position, dans laquelle la barrière d'isolation (3) est déplacée à travers l'ouverture (7),
**caractérisé en ce que**
la barrière d'isolation (3) est disposée en pouvant se déplacer sur un des composants (4) électriques de telle manière qu'à l'état déplacé de la barrière d'isolation (3) à travers l'ouverture (7), la distance d'isolation entre au moins un contact (5') d'au moins un composant (4) et au moins un contact (5") d'au moins un autre composant (4) est augmentée.
